# EUROPEAN PATENT APPLICATION

(11) **EP 4 502 718 A1**
(43) Date of publication of application: **05.02.2025**
(21) Application number: 22961726.1
(22) Date of filing: 13.10.2022
(51) Int. Cl.: G02F 1/133

(54) **DISPLAY MODULE AND DISPLAY DEVICE**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: WEI, Junbo, Beijing 100176 (CN); YANG, Shengji, Beijing 100176 (CN); LU, Pengcheng, Beijing 100176 (CN); HUANG, Kuanta, Beijing 100176 (CN); BAI, Xiao, Beijing 100176 (CN); TIAN, Yuanlan, Beijing 100176 (CN)
(74) Representative: Studio Torta S.p.A.
(86) International application number: PCT/CN2022/125003
(87) International publication number: WO 2024/077535

(57) **Abstract**

The present disclosure provides a display module and a display device. The display module includes: an array substrate including a base substrate; a first cover plate on a light-emitting side of the array substrate; a second cover plate on a side of the first cover plate away from the array substrate; and a first light-shielding layer on a side of the first cover plate close to the array substrate. An orthographic projection of the first light-shielding layer on the base substrate falls within an orthographic projection of the first cover plate on the base substrate, and the first light-shielding layer is arranged around an edge of the first cover plate.

## Description

### TECHNICAL FIELD

The present disclosure relates to the field of display technology, and in particular to a display module and a display device comprising the display module.

### BACKGROUND

Micro organic light emitting diode (Micro-OLED) display device is a new type of OLED display device based on silicon substrate. An OLED comprising the silicon substrate has advantages such as small size and high resolution, and can be prepared by mature integrated circuit process to realize active addressing of pixels. Micro OLED display device comprising the silicon substrate may be applied to fields such as near-eye display, virtual reality (VR), augmented reality (AR).

### SUMMARY

According to an aspect of the present disclosure, a display module is provided. The display module comprises an array substrate comprising a base substrate; a first cover plate on a light-emitting side of the array substrate; a second cover plate on a side of the first cover plate away from the array substrate; and a first light-shielding layer on a side of the first cover plate close to the array substrate. The orthographic projection of the first light-shielding layer on the base substrate falls within an orthographic projection of the first cover plate on the base substrate, and the first light-shielding layer is arranged around an edge of the first cover plate.

In some embodiments, the first light-shielding layer is annular in shape and is arranged around four edges of the first cover plate, the array substrate comprises a display region, and an orthographic projection of the display region on the base substrate does not overlap with the orthographic projection of the first light-shielding layer on the base substrate.

In some embodiments, the array substrate further comprises a second light-shielding layer, the second light-shielding layer is arranged at least around a boundary of a display region, and an orthographic projection of the second light-shielding layer on the base substrate falls within an orthographic projection of the display region on the base substrate.

In some embodiments, a thickness of the first light-shielding layer is greater than a thickness of the second light-shielding layer.

In some embodiments, the first light-shielding layer and the second light-shielding layer are selected from one of: an ink, a black conductive glue, a black resin, a stacked structure comprising at least two color filter layers of different colors.

In some embodiments, the first light-shielding layer is arranged around four edges of the first cover plate, the array substrate comprises a display region, and an orthographic projection of the display region on the base substrate partially overlaps with the orthographic projection of the first light-shielding layer on the base substrate.

In some embodiments, the first light-shielding layer comprises a first portion and a second portion, an orthographic projection of the first portion on the base substrate falls within the orthographic projection of the display region on the base substrate, an orthographic projection of the second portion on the base substrate does not overlap with the orthographic projection of the display region on the base substrate, and a thickness of the first portion is smaller than a thickness of the second portion.

In some embodiments, the display module further comprises an adhesive and a fixture. The second cover plate comprises a first surface facing the first cover plate, a second surface opposite to the first surface, and a side surface connecting the first surface and the second surface, the adhesive is disposed on the side surface of the second cover plate, and the second cover plate is adhered to the fixture via the adhesive, and a part of a surface of the first cover plate away from the array substrate is in contact with the adhesive, and the first cover plate is adhered to the second cover plate via the adhesive.

In some embodiments, an orthographic projection of the adhesive on the base substrate falls within the orthographic projection of the first light-shielding layer on the base substrate.

In some embodiments, an orthographic projection of the adhesive on the base substrate falls within an orthographic projection of the fixture on the base substrate.

In some embodiments, the display module further comprises a fixture, edges of the first cover plate and the second cover plate are in direct contact with the fixture.

In some embodiments, a thickness of the second cover plate is smaller than a thickness of the first cover plate.

In some embodiments, a distance between the first cover plate and the second cover plate is smaller than a distance between the first cover plate and the array substrate.

In some embodiments, the second cover plate comprises a first surface facing the first cover plate, a second surface opposite to the first surface, and a side surface connecting the first surface and the second surface, the first cover plate comprises a third surface facing the array substrate, a fourth surface opposite to the third surface, and a side surface connecting the third surface and the fourth surface, and a roughness of the side surface of the second cover plate is greater than a roughness of the side surface of the first cover plate.

In some embodiments, a roughness of the third surface of the first cover plate is greater than a roughness of the fourth surface of the first cover plate.

In some embodiments, the array substrate further comprises a bonding region, the bonding region is provided with a bonding electrode, and the orthographic projection of the first cover plate on the base substrate does not overlap with an orthographic projection of the bonding electrode on the base substrate, and an orthographic projection of the second cover plate on the base substrate at least partially overlaps with the orthographic projection of the bonding electrode on the base substrate.

In some embodiments, the first light-shielding layer comprises a first section, a second section, a third section and a fourth section connected end to end, a distance between an orthographic projection of the first section on the base substrate and the orthographic projection of the bonding electrode on the base substrate is less than distances between orthographic projections of the second section, the third section, and the fourth section on the base substrate and the orthographic projection of the bonding electrode on the base substrate, respectively. A width of the first section along a first direction is smaller than a width of the third section along the first direction, and the width of the first section along the first direction is smaller than widths of the second section and the fourth section along a second direction, the first direction intersects with the second direction.

In some embodiments, the display module further comprises a lens on a side of the second cover plate away from the first cover plate. The lens comprises a first end and a second end opposite to the first end in a direction perpendicular to a main optical axis of the lens, an orthographic projection of the first end on the base substrate falls outside an orthographic projection of the second cover plate on the base substrate but falls within the orthographic projection of the first cover plate on the base substrate, and an orthographic projection of the second end on the base substrate falls outside the orthographic projection of the second cover plate on the base substrate but falls within the orthographic projection of the first cover plate on the base substrate.

In some embodiments, an orthographic projection of the second cover plate on the base substrate falls within the orthographic projection of the first cover plate on the base substrate.

According to another aspect of the present disclosure, a display device comprising the display module described in any of the previous embodiments is provided.

### BRIEF DESCRIPTION OF THE DRAWINGS

In order to more clearly describe the technical solutions in the embodiments of the present disclosure, the drawings needed in the embodiments will be briefly described below. Obviously, the drawings described below are only some embodiments of the present disclosure. For those of ordinary skill in the art, other drawings may also be obtained based on these drawings without undue experimentation.
Fig. 1 illustrates a schematic plan view of a partial structure of a display module according to an embodiment of the present disclosure;
Fig. 2 illustrates a schematic sectional view taken along the line AA' of Fig. 1;
Fig. 3 illustrates a structural schematic diagram of a display module according to an embodiment of the present disclosure;
Fig. 4 illustrates a schematic sectional view of a partial structure of a display module according to an embodiment of the present disclosure;
Fig. 5 illustrates a schematic plan view of a first light-shielding layer according to an embodiment of the present disclosure;
Fig. 6 illustrates a schematic plan view of a partial structure of a display module according to an embodiment of the present disclosure;
Fig. 7 illustrates a schematic sectional view taken along the line BB' of Fig. 6;
Fig. 8 illustrates a schematic sectional view of a partial structure of a display module according to an embodiment of the present disclosure;
Fig. 9 illustrates a schematic plan view of the first light-shielding layer of Fig. 8;
Fig. 10 illustrates a schematic sectional view of a partial structure of a display module according to an embodiment of the present disclosure; and
Fig. 11 illustrates a block diagram of a display device according to an embodiment of the present disclosure.

### DETAILED DESCRIPTION OF THE DISCLOSURE

The technical solutions in the embodiments of the present disclosure will be clearly described in the following with reference to the drawings. Apparently, the described embodiments are only some, but not all, of the embodiments of the present disclosure. Based on the embodiments in the present disclosure, all other embodiments obtained by those of ordinary skill in the art without undue experimentation belong to the protection scope of the present disclosure.

Micro OLED display device has the advantages of small size and high resolution, and can be prepared by mature integrated circuit process (such as the complementary metal oxide semiconductor process), thus realizing active addressing of pixels. In addition, the micro OLED display device can be integrated with various circuits such as time control register (T-CON), over current protection circuit (OCP), so as to realize light weight. Micro OLED display device may be widely used in fields such as near-eye display, VR, AR, especially in AR/VR head-mounted display devices. When the micro OLED display device is applied to near-eye display equipment, the fixed position of the display panel is very important for a user, because it will affect the experience of the user. In general, positioning is realized by the cover plate on the top side of the display panel, the cover plate allows light to exit from the display panel and has protective effect on the display panel. However, it is very easy to introduce pollutants such as dust on the surface of the cover plate during the manufacturing process of the display device, and these dust will enter the display device through the gap of the cover plate, so that the display device will appear unexpected "black spots" when displaying pictures. In addition, some unexpected light in the display panel will be emitted through the edge gap of the cover plate, thus affecting the display effect of the display panel.

In view of this, the present application proposes an improved display module and display device, which can solve the problem of stains on the surface of the cover plate, and can avoid unexpected light from being emitted from the edge of the cover plate.

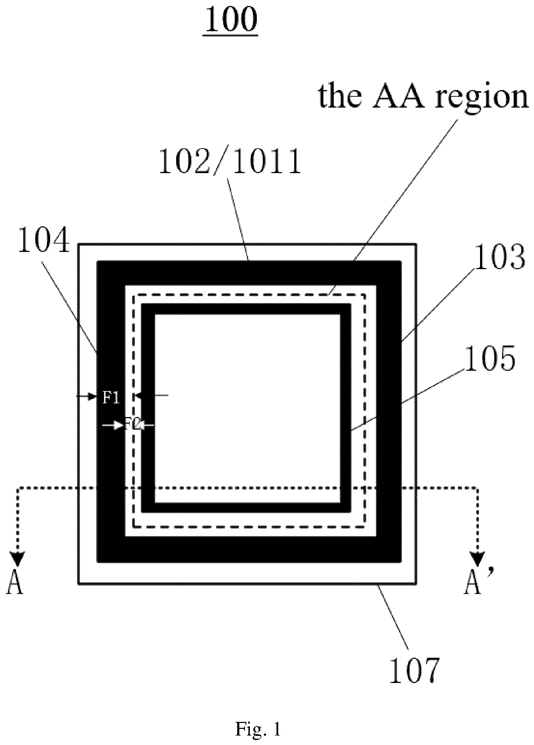

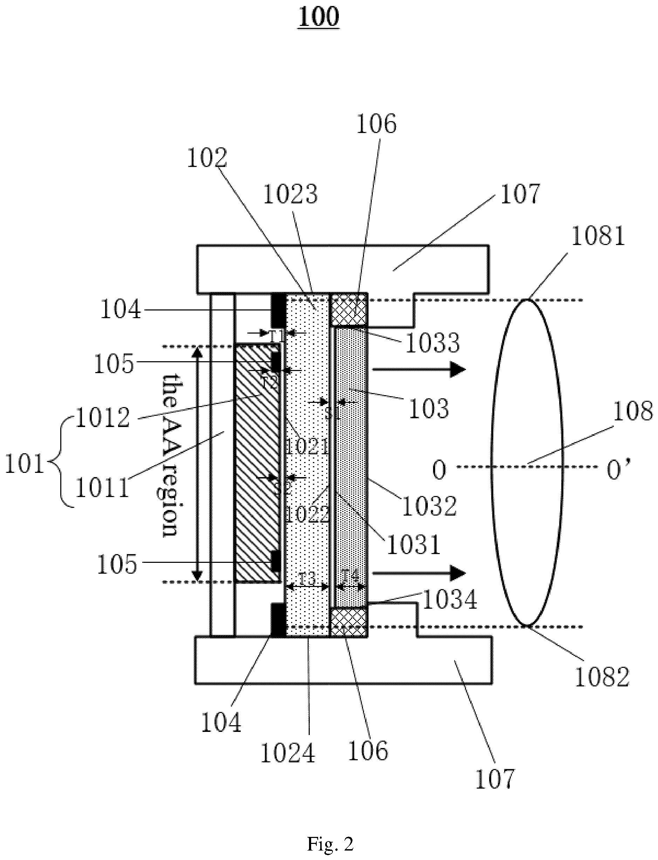

Fig. 1 illustrates a schematic plan view of a display module 100, and some structures illustrated in Fig. 2 are taken through the line AA' of Fig. 1, that is, other structures illustrated in Fig. 2 can be taken through the line AA' of Fig. 1 except the lens 108. As illustrated in Figs. 1 and 2, the display module 100 comprises: an array substrate 101 comprising a base substrate 1011; a first cover plate 102 at a light-emitting side of the array substrate 101; a second cover plate 103 on a side of the first cover plate 102 away from the array substrate 101; and a first light-shielding layer 104 on a side of the first cover plate 102 close to the array substrate 101. An orthographic projection of the first light-shielding layer 104 on the base substrate 1011 falls within an orthographic projection of the first cover plate 102 on the base substrate 1011, and the first light-shielding layer 104 is arranged around the edge of the first cover plate 102.

"The edge of the first cover plate 102" can be understood as the side of the first cover plate 102. For example, when the shape of the first cover plate 102 is rectangular, "the edge of the first cover plate 102" refers to four sides of the first cover plate 102.

By providing the second cover plate 103 in the display module 100, even if there is dust in the environment, the dust will only fall on the surface of the second cover plate 103 at most, but not on the surface of the first cover plate 102, thus preventing the dust from entering the display module 100 through the gap between the first cover plate 102 and the array substrate 101, and the display module 100 will not appear "black spots" when displaying a picture, thus not affecting the display effect of the display module 100. In addition, by adding the second cover plate 103, the display module 100 can adopt a double cover plate structure to protect the array substrate 101, so that the electrostatic tolerance of the display module 100 is further enhanced, and the problem of electrostatic damage can be avoided. Moreover, by arranging the first light-shielding layer 104 at the edge of the first cover plate 102, the light emitted by the array substrate 101 can be reduced or even prevented from being emitted from the edges of the first cover plate 102 and the second cover plate 103, so that the phenomenon of light leakage at the edges of the display module 100 can be avoided, the display effect of the display module 100 can be improved, and the user experience can be further improved.

In some embodiments, as illustrated in Fig. 1, the first light-shielding layer 104 is annular in shape and arranged around the four edges of the first cover plate 102. The array substrate 101 comprises the base substrate 1011 and a stacked structure 1012. The stacked structure 1012 comprises, for example, an anode, a cathode, an organic light-emitting layer, an encapsulation layer, etc., which will be described later, and will not be described too much here. The array substrate 101 comprises a display region (namely AA region), and the orthographic projection of the display region on the base substrate 1011 does not overlap with the orthographic projection of the first light-shielding layer 104 on the base substrate 1011. It should be pointed out that the annular shape of the first light-shielding layer 104 adapts to the shape of the first cover plate 102. For example, when the shape of the first cover plate 102 is rectangular, the first light-shielding layer 104 is a rectangular ring; when the shape of the first cover plate 102 is square, the first light-shielding layer 104 is a square ring. The first light-shielding layer 104 is located at the periphery of the display region, so the orthographic projection of the display region on the base substrate 1011 does not overlap with the orthographic projection of the first light-shielding layer 104 on the base substrate 1011, so that the normal emission of the light emitted from the display region of the array substrate 101 will not be affected. By arranging the first light-shielding layer 104 around the four edges of the first cover plate 102, the light emitted by the array substrate 101 can be better prevented from being emitted from the edges of the first cover plate 102 and the second cover plate 103, so that the phenomenon of light leakage at the edges of the display module 100 can be further avoided, and the display effect of the display module 100 and the user experience can be further improved.

In some embodiments, the array substrate 101 may further comprise a second light-shielding layer 105, which is at least arranged around the boundary of the display region. The orthographic projection of the second light-shielding layer 105 on the base substrate 1011 falls within the orthographic projection of the display region on the base substrate 1011. The second light-shielding layer 105 may absorb the reflected light of the peripheral metal lines of the array substrate 101. The thickness T1 of the first light-shielding layer 104 may be greater than the thickness T2 of the second light-shielding layer 105. In this way, the gap between the array substrate 101 and the first cover plate 102 can be prevented from being too large, so that the first cover plate 102 can be attached to the array substrate 101 more firmly and closely.

The first light-shielding layer 104 and the second light-shielding layer 105 may be selected from one of: an ink, a black conductive glue, a black resin, a stacked structure comprising at least two color filter layers of different colors. When the first light-shielding layer 104 and the second light-shielding layer 105 are composed of the stacked structure with color filter layers of different colors, the first light-shielding layer 104 and the second light-shielding layer 105 comprise stacked color filter layers with at least two colors. In an example, the first light-shielding layer 104 and the second light-shielding layer 105 comprise a red color filter layer and a green color filter layer which are stacked. In an alternative example, the first light-shielding layer 104 and the second light-shielding layer 105 comprise a red color filter layer, a green color filter layer, and a blue color filter layer which are stacked. The color filter layer in the first light-shielding layer 104 and the second light-shielding layer 105 may be prepared by the same process as the color filter layer with the same color in the display region, thereby saving the process flow and improving the production efficiency.

Referring to Figs. 1 and 2, in some embodiments, the display module 100 may further comprise an adhesive 106 and a fixture 107. The second cover plate 103 comprises a first surface 1031 facing the first cover plate 102, a second surface 1032 opposite to the first surface 1031, and side surfaces (only side surfaces 1033 and 1034 are illustrated in Fig. 2) connecting the first surface 1031 and the second surface 1032. The adhesive 106 is arranged on the side surfaces of the second cover plate 103, and the second cover plate 103 is adhered to the fixture 107 via the adhesive 106. A part of the fourth surface 1022 of the first cover plate 102 away from the array substrate 101 is in contact with the adhesive 106, and the first cover plate 102 is adhered to the second cover plate 102 via the adhesive 106. With the adhesive 106, both the first cover plate 102 and the second cover plate 103 can be fixed to the fixture 107, thus realizing the mechanical fixing. In some embodiments, the adhesive 106 may be black glue. In this case, the adhesive 106 may additionally prevent the light of the display module 100 from being emitted from the edge of the first cover plate 102, thereby further avoiding the phenomenon of light leakage at the edge. The fixture 107 may be realized as an opto-mechanical structural member, which plays a role in clamping and fixing the display module 100.

In an embodiment, the adhesive 106 may be disposed around all side surfaces of the second cover plate 103. In an alternative embodiment, the adhesive 106 may cover the fourth surface 1022 of the first cover plate 102 and all side surfaces of the second cover plate 103. Metal Ag ions may be added to the adhesive 106 to improve the heat dissipation. The orthographic projection of the adhesive 106 on the base substrate 1011 falls within the orthographic projection of the first light-shielding layer 104 on the base substrate 1011. The adhesive 106, especially the transparent adhesive, has the function of converging and refracting light. If ambient light irradiates the adhesive 106 and is deflected by the adhesive 106, the deflected light will eventually be emitted from the second cover plate 103 uncontrollably, which will affect the display effect of the display module 100. In the embodiment of the present disclosure, the orthographic projection of the adhesive 106 on the base substrate 1011 falls within the orthographic projection of the first light-shielding layer 104 on the base substrate 1011, in other words, the first light-shielding layer 104 shields the adhesive 106, in this way, even if the ambient light irradiates the adhesive 106, the ambient light will be shielded and absorbed by the first light-shielding layer 104, so that the display effect of the display module 100 will not be affected. Additionally, the orthographic projection of the adhesive 106 on the base substrate 1011 may also fall within the orthographic projection of the fixture 107 on the base substrate 1011. As illustrated in Fig. 2, the fixture 107 comprises a protruding structure, and the orthographic projection of the adhesive 106 on the base substrate 1011 falls within the orthographic projection of the protruding structure on the base substrate 1011. The fixture 107 shields the adhesive 106, the adhesive 106 may be prevented from being irradiated by ambient light, so that the display effect of the display module 100 will not be affected.

The thickness T4 of the second cover plate 103 is smaller than the thickness T3 of the first cover plate 102. In some embodiments, the thickness T4 of the second cover plate 103 may be 0.5-0.7 mm, and the thickness T3 of the first cover plate 102 may be 0.7-1.3 mm. By making the thickness T4 of the second cover plate 103 smaller than the thickness T3 of the first cover plate 102, the second cover plate 103 will not greatly affect the light transmittance of the display module 100 while playing a dustproof role. The transmittance of the second cover plate 103 is greater than 95%. By optimizing the thickness of the first cover plate 102 and the second cover plate 103, the imaging focal length can be adjusted, which is beneficial to the cooperation with the lens 108.

As illustrated in Fig. 2, the distance S1 between the first cover plate 102 and the second cover plate 103 is smaller than the distance S2 between the first cover plate 102 and the array substrate 101. In some embodiments, the distance S1 between the first cover plate 102 and the second cover plate 103 is 3-5 µm, and the distance S2 between the first cover plate 102 and the array substrate 101 is 10-20 µm. By making the distance S1 between the first cover plate 102 and the second cover plate 103 as small as possible, the loss of light emitted from the array substrate 101 by the cover plate can be reduced to the greatest extent, which is beneficial to improving the light output of the display module 100.

In some embodiments, the orthographic projection of the second cover plate 103 on the base substrate 1011 falls within the orthographic projection of the first cover plate 102 on the base substrate 1011. In an example, the orthographic projection of the first cover plate 102 on the base substrate 1011 completely overlaps with the base substrate 1011. In an alternative example, the orthographic projection of the first cover plate 102 on the base substrate 1011 falls within the first base substrate 1011, for example, each side of the first cover plate 102 is about 150 µm shorter than the corresponding side of the first base substrate 1011. The first cover plate 102 is adhered to the array substrate 101 by an adhesive (for example, an optically clear adhesive (OCA) or an optical clear resign (OCR)), and the second cover plate 103 is adhered to the first cover plate 102 by the adhesive 106.

As illustrated in Fig. 1, the orthographic projection of the display region on the base substrate 1011 falls within the orthographic projections of the first cover plate 102 and the second cover plate 103 on the base substrate 1011. In an embodiment, the spacing F1 between the orthographic projection of the edge of the first cover plate 102 on the base substrate 1011 and the corresponding boundary of the display region on the base substrate 1011 is 800-1200 µm, and the spacing F2 between the orthographic projection of the edge of the second cover plate 103 on the base substrate 1011 and the corresponding boundary of the display region on the base substrate 1011 is 100-200 µm. By this arrangement, it can be ensured that the sizes of the first cover plate 102 and the second cover plate 103 are larger than that of the display region, so that the emitted light of the display region will not be affected, and the first cover plate 102 and the second cover plate 103 may also be well matched with the lens 108. In an alternative embodiment, the second cover plate 103 has the same size as the first cover plate 102, the lens 108 is in direct contact with the second surface 1032 of the second cover plate 103, and the orthographic projections of the first end 1081 and the second end 1082 of the lens 108 on the base substrate 1011 respectively fall outside the orthographic projection of the second cover plate 103 on the base substrate 1011.

The second cover plate 103 comprises the first surface 1031 facing the first cover plate 102, the second surface 1032 opposite to the first surface 1031, and side surfaces (only side surfaces 1033 and 1034 are illustrated in Fig. 2) connecting the first surface 1031 and the second surface 1032. The first cover plate 102 comprises a third surface 1021 facing the array substrate 101, a fourth surface 1022 opposite to the third surface 1021, and side surfaces (only side surfaces 1023 and 1024 are illustrated in Fig. 2) connecting the third surface 1021 and the fourth surface 1022. The roughness of the side surface of the second cover plate 103 is greater than the toughness of the side surface of the first cover plate 102. By making the side surface of the second cover plate 103 have greater roughness, on the one hand, it can be ensured that the first cover plate 102 and the second cover plate 103 can be closely attached; on the other hand, the light emitted by the array substrate 101 is incident on the first surface 1031 of the second cover plate 103, and then passes through the first surface 1031 to be incident on the side surface with greater roughness. The light incident on the side surface will change the traveling direction under the action of the side surface, and finally will be emitted from the second surface 1032 of the second cover plate 103, thus effectively preventing the light emitted by the array substrate 101 from being emitted from the side surface of the second cover plate 103, avoiding the phenomenon of light leakage at the side of the display module 100, and further improving the user experience. The aforementioned "under the action of the side surface" may comprise one or more refractions and/or reflections of light at the side surface of the second cover plate 103.

In some embodiments, the roughness of the third surface 1021 of the first cover plate 102 is greater than the roughness of the fourth surface 1022 of the first cover plate 102. By making the third surface 1021 of the first cover plate 102 have a larger roughness, not only can the first light-shielding layer 104 be firmly bonded to the third surface 1021 of the first cover plate 102, but also most of the light emitted from the array substrate 101 can pass through the third surface 1021 and the fourth surface 1022 of the first cover plate 102 and be incident onto the second cover plate 103, instead of exiting from the side surface of the first cover plate 102, therefore, light leakage at the side of the display module 100 can be further avoided.

As illustrated in Fig. 2, the display module 100 may further comprise a lens 108 located on a side of the second cover plate 103 away from the first cover plate 102. The lens 108 comprises a first end 1081 and a second end 1082 opposite to the first end 1081 in the direction perpendicular to the main optical axis OO' of the lens. The orthographic projection of the first end 1081 on the base substrate 1011 falls outside the orthographic projection of the second cover plate 103 on the base substrate 1011, but falls within the orthographic projection of the first cover plate 102 on the base substrate 1011. The orthographic projection of the second end 1082 on the base substrate 1011 falls outside the orthographic projection of the second cover plate 103 on the base substrate 1011, but falls within the orthographic projection of the first cover plate 102 on the base substrate 1011. For example, the distance between the orthographic projection of the first end 1081 of the lens 108 on the base substrate 1011 and the orthographic projection of the edge of the second cover plate 103 corresponding to the first end 1081 on the base substrate 1011 is 50-100 µm, the distance between the orthographic projection of the second end 1082 of the lens 108 on the base substrate 1011 and the orthographic projection of the edge of the second cover plate 103 corresponding to the second end 1082 on the base substrate 1011 is 50-100 µm, the distance between the orthographic projection of the first end 1081 of the lens 108 on the base substrate 1011 and the orthographic projection of the edge of the first cover plate 102 corresponding to the first end 1081 on the base substrate 1011 is 50-100 µm, and the distance between the orthographic projection of the second end 1082 of the lens 108 on the base substrate 1011 and the orthographic projection of the edge of the first cover plate 102 corresponding to the second end 1082 on the base substrate 1011 is 50-100 µm. Through this arrangement, the lens 108 can better concentrate the light emitted from the array substrate 101, thus achieving the optimal optical effect.

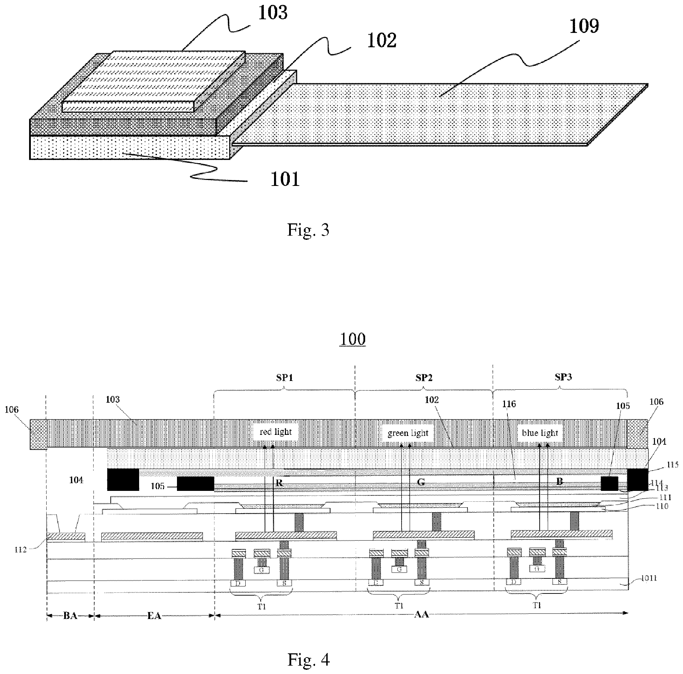

Fig. 3 illustrates a simplified schematic diagram of the display module 100. The display module 100 may be a silicon-based OLED display module and may be a flexible FPC circuit board type module structure. In some embodiments, the surface of the second cover plate 103 may be additionally provided with an antireflection film, so that on one hand, the second cover plate 103 can play a dustproof role, i.e. prevent dust from falling on the surface of the first cover plate 102, on the other hand, the second cover plate 103 can realize the color selection of the emitted light, improve the color of the emitted light at the edge, and improve the phenomenon that the product is red or blue at a large viewing angle, thereby optimizing the image focusing and display effect of the second cover plate 103. The array substrate 101 comprise the base substrate 1011 and the stacked structure 1012. The stacked structure 1012 comprises at least OLED device to realize light-emitting, and the light emitted by the OLED device can be emitted through the first cover plate 102 and the second cover plate 103. A driving circuit is integrated in the array substrate 101 to realize voltage input driving of light-emitting pixels. The flexible printed circuit board 109 is connected to the array substrate 101 to transmit external signals to the array substrate 101.

Fig. 4 illustrates a schematic sectional view of a partial structure of the display module 100. As illustrated in Fig. 4, in addition to the display region (i.e. the AA region), the array substrate 101 also comprises a peripheral region (i.e. the EA region) and a bonding region (i.e. the BA region), and the peripheral region is arranged around the display region. The display region illustrates three sub-pixels SP1, SP2 and SP3, which can emit red light, green light and blue light respectively. Accordingly, the color film layer 116 comprises a red filter layer R, a green filter layer G and a blue filter layer B. In the example of Fig. 4, the first light-shielding layer 104 and the second light-shielding layer 105 may be composed of a stacked structure of a red filter layer R and a green filter layer G. During the preparation process, the red filter layer R of the first light-shielding layer 104 and the second light-shielding layer 105 may be formed in the same process as the red filter layer R of the color film layer 116, and the green filter layer G of the first light-shielding layer 104 and the second light-shielding layer 105 may be formed in the same process as the green filter layer G of the color film layer 116.

The bonding region is provided with the bonding electrodes 112. The orthographic projection of the first cover plate 102 on the base substrate 1011 does not overlap with the orthographic projection of the bonding electrodes 112 on the base substrate 1011, and the orthographic projection of the second cover plate 103 on the base substrate 1011 at least partially overlaps with the orthographic projection of the bonding electrodes 112 on the base substrate 1011. By making the first cover plate 102 not cover the bonding region, the first cover plate 102 and the bonding electrodes 112 do not overlap, thus providing a spacious space for the bonding of the bonding electrodes 112 and the FPC 109, which is beneficial to the bonding operation. By extending the second cover plate 103 to the bonding region and overlapping with the bonding electrodes 112, the second cover plate 103 provides a clamping position with a larger size, which is beneficial to the clamping of the second cover plate 103 by the fixture 107.

The array substrate 101 of the display module 100 may further comprise a driving transistor T1 comprising components such as a gate G, a source S, a drain G, and the source S is electrically connected with the first electrode 110 of the OLED light-emitting device through a conductive layer to drive the OLED light-emitting device to emit light.

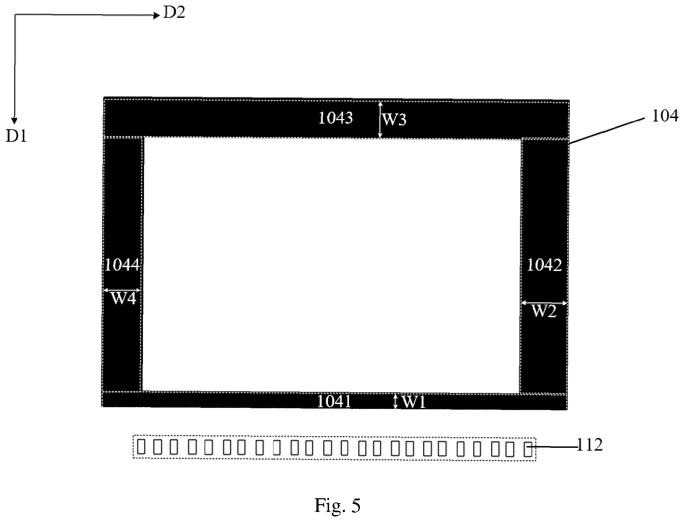

Fig. 5 illustrates a schematic plan view of the first light-shielding layer 104. As illustrated in Fig. 5, the first light-shielding layer 104 comprises a first section 1041, a second section 1042, a third section 1043, and a fourth section 1044 connected end to end. The distance between the orthographic projection of the first section 1041 on the base substrate 1011 and the orthographic projection of the bonding electrodes 112 on the base substrate 1011 is smaller than the distances between the orthographic projections of the second section 1042, the third section 1043 and the fourth section 1044 on the base substrate 1011 and the orthographic projection of the bonding electrodes 112 on the base substrate 1011, respectively. The width W1 of the first section 1041 along a first direction D 1 is smaller than the width W3 of the third section 1043 along the first direction D1, and the width W1 of the first section 1041 along the first direction D1 is smaller than the width W2 of the second section 1042 and the width W4 of the fourth section 1044 along a second direction D2, the first direction D1 intersects with the second direction D2, for example, the first direction D1 is perpendicular to the second direction D2. In other words, the first section 1041 is closer to the bonding electrode 112 than the other three sections, and the first section 1041 has the smallest width among the four sections. In an embodiment, the width of each section of the first light-shielding layer 104 is 100-450 µm, but it is necessary to ensure that the width W1 of the first section 1041 is smaller than the widths of the other three sections. Such a width design may not only play the role of shading, but also play the role of blocking dust and preventing external dust from entering the display module 100.

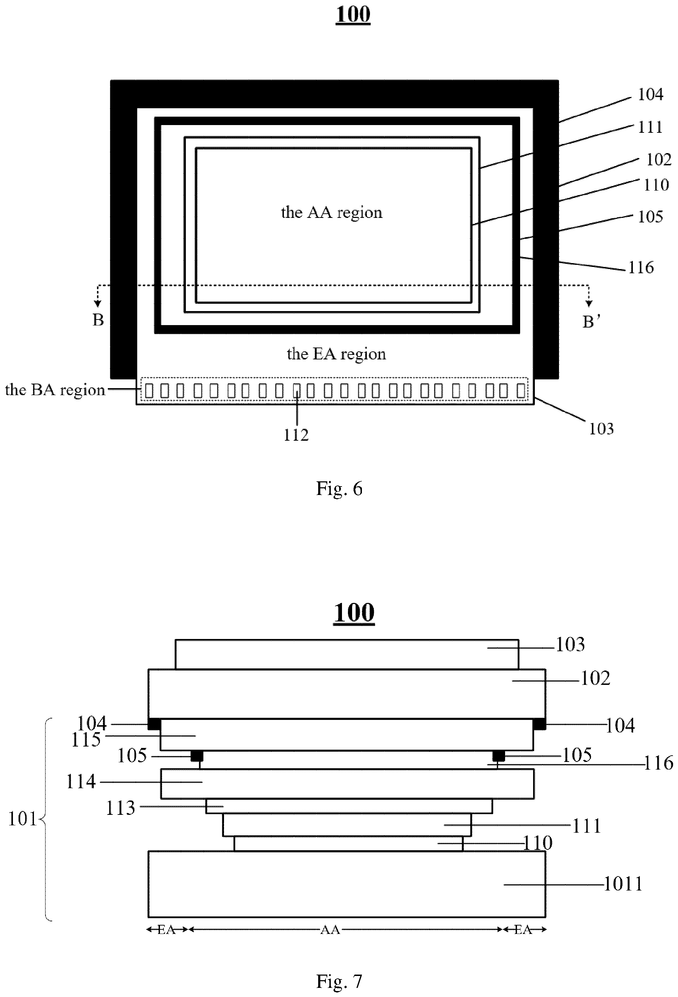

Fig. 6 illustrates a schematic plan view of a partial structure of the display module 100, Fig. 7 illustrates a schematic sectional view taken along the line BB' of Fig. 6, and Figs. 6 and 7 illustrate a more detailed structures of the display module 100. As illustrated in Figs. 6 and 7, the array substrate 101 of the display module 100 comprises a display region (AA region), a peripheral region (EA region) surrounding the display region, and a bonding region (BA region). The stacked structure 1012 of the array substrate 101 may comprise a first electrode 110, a light-emitting layer 111, a second electrode 113, a first encapsulation layer 114, a color film layer 116, and a second encapsulation layer 115 stacked in sequence on the base substrate 1011. The base substrate 1011 may be a silicon substrate. The first electrode 110 may be an anode and the second electrode 113 may be a cathode. The material of the anode comprises but is not limited to ITO, which has high transmittance and high work function. The cathode may be a transparent structure, and the cathode may be made of Mg, Ag and alloy materials comprising Mg and/or Ag. The light-emitting layer 111 is usually made of organic materials, using the light-emitting characteristics of organic materials and under the action of voltage or current, holes generated from the first electrode 110 and electrons generated from the second electrode 113 recombine at the light-emitting layer 111 to form excitons, thus realizing light-emitting. The array substrate 101 may further comprise a pixel driving circuit (not illustrated) formed on the base substrate 1011, and the pixel driving circuit may be manufactured by a 110 nm semiconductor process. The color film layer 116 is arranged between the second encapsulation layer 115 and the first encapsulation layer 114, and the color film layer 116 is arranged corresponding to the light-emitting layer 111, so as to realize the color display of the emitted light. The combination of the second encapsulation layer 115 and the first encapsulation layer 114 can effectively package the device, effectively block water vapor and oxygen, and achieve the purposes of protecting the device and prolonging the service life. In some embodiments, the second encapsulation layer 115 and the first encapsulation layer 114 may use one or more of organic materials and inorganic materials with good sealing performance, such as silicon oxide, silicon nitride and the like. The second encapsulation layer 115, the first cover plate 102 and the second cover plate 103 are sequentially arranged above the color film layer 116, which can better protect the color film layer 116. The first cover plate 102 and the second cover plate 103 may be transparent materials, such as mother glass with high transmittance.

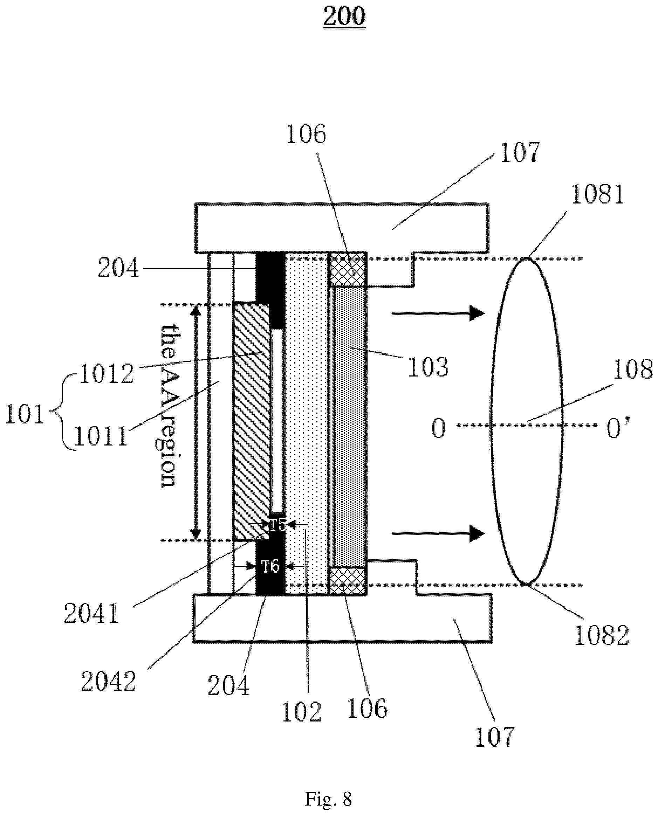

Fig. 8 illustrates a schematic sectional view of a partial structure of a display module 200. The display module 200 illustrated in Fig. 8 has basically the same configuration as the display module 100 except for the first light-shielding layer 204, and therefore, the same reference numerals are used to refer to the same parts. Therefore, the detailed functions and effects of components with the same reference numerals as those of the display module 100 in Fig. 8 may be referred to the description of the display module 100, and will not be repeated here. For the sake of brevity, only the differences will be described below.

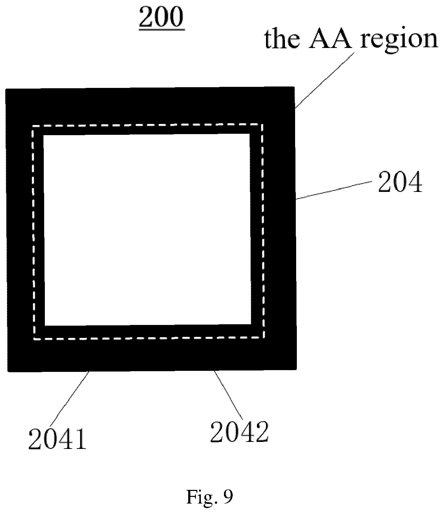

As illustrated in Fig. 8, the display module 200 only comprises the first light-shielding layer 204, does not comprise the second light-shielding layer 105 as mentioned above. Fig. 9 illustrates a schematic plan view of the first light-shielding layer 204. As illustrated in Figs. 8 and 9, the first light-shielding layer 204 is arranged around the four edges of the first cover plate 102, and the orthographic projection of the display region on the base substrate 1011 partially overlaps with the orthographic projection of the first light-shielding layer 204 on the base substrate 1011. In other words, the first light-shielding layer 204 extends from the edge of the first cover plate 102 to the display region, so that the aforementioned second light-shielding layer 105 may be omitted, but the first light-shielding layer 204 can function as both the first light-shielding layer 104 and the second light-shielding layer 105. As illustrated in Figs. 8 and 9, the first light-shielding layer 204 comprises a first portion 2041 and a second portion 2042, the orthographic projection of the first portion 2041 on the base substrate 1011 falls within the orthographic projection of the display region on the base substrate 1011, the orthographic projection of the second portion 2042 on the base substrate 1011 does not overlap with the orthographic projection of the display region on the base substrate 1011, and the thickness T5 of the first portion 2041 is smaller than the thickness T6 of the second portion 2042. By making the thickness T5 of the overlapping region between the first light-shielding layer 204 and the display region smaller than the thickness T6 of the nonoverlapping region between the first light-shielding layer 204 and the display region, the gap between the array substrate 101 and the first cover plate 102 can be avoided from being too large, which is helpful for the first cover plate 102 to closely adhere to the array substrate 101.

Other technical effects of the display module 200 may refer to the technical effects of the display module 100, and for the sake of brevity, the technical effects of the display module 200 will not be repeated here.

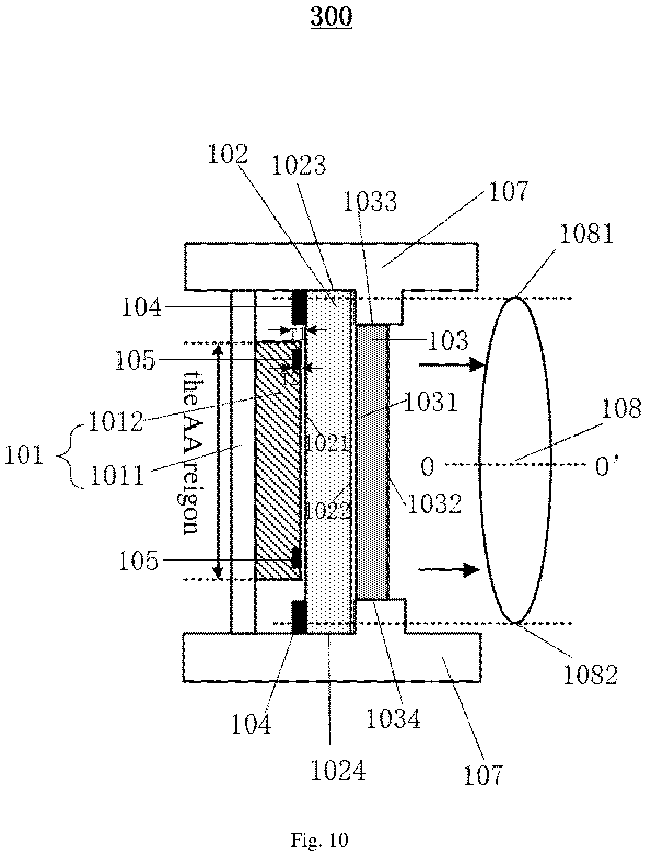

Fig. 10 illustrates a schematic sectional view of a partial structure of the display module 300. The display module 300 illustrated in Fig. 10 has basically the same structure as the display module 100 except that the first cover plate 102 and the second cover plate 103 are bonded to the fixture 107 in a different way, and therefore, the same reference numerals are used to refer to the same parts. Therefore, the detailed functions and effects of components with the same reference numerals as those of the display module 100 in Fig. 10 may be referred to the description of the display module 100, and will not be repeated here. For the sake of brevity, only the differences will be described below.

As illustrated in Fig. 10, no adhesive 106 is provided on the side surface of the second cover plate 103. Alternatively, the side surfaces of the first cover plate 102 and the second cover plate 103 are both in direct contact with the fixture 107, thereby being fixed to the fixture 107. Specifically, the edge of the second cover plate 103 is in direct contact with the protruding structure of the fixture 107, and the side edge of the fixture 107 can press the edges of the first cover plate 102 and the second cover plate 103, thereby realizing the fixing. By making the fixture 107 closely contact with the edges of the first cover plate 102 and the second cover plate 103 without gaps, the light emitted from the array substrate 101 can be prevented from leaking from the gaps. The opening size of the fixture 107 of Fig. 10 may be larger than that of the fixture 107 of Fig. 1.

Other technical effects of the display module 300 may refer to the technical effects of the display module 100, and for the sake of brevity, the technical effects of the display module 300 will not be repeated here.

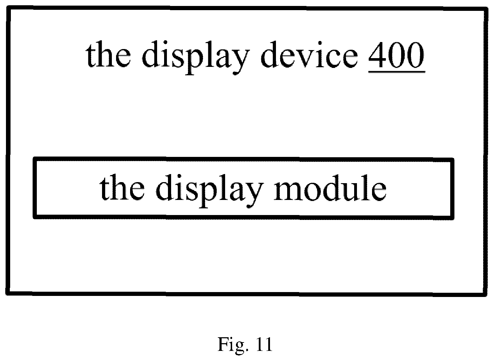

Fig. 11 illustrates a block diagram of a display device 400 comprising the display module described in any of the previous embodiments. The display device 400 may be any suitable device with a display function, comprising but not limited to a head-mounted display device. The display device 400 may be applied to fields such as near-eye display, virtual reality, augmented reality, and brings excellent visual experience to users.

The display device 400 may have basically the same technical effects as the display module described in the previous embodiments, and for the sake of brevity, the technical effects of the display device 400 will not be repeated here.

It will be understood that although the terms first, second, third, etc. may be used herein to describe various elements, components, regions, layers and/or portions, these elements, components, regions, layers and/or portions should not be limited by these terms. These terms are only used to distinguish an element, component, region, layer or portion from another element, component, region, layer or portion. Thus, a first element, component, region, layer or portion discussed above could be termed a second element, component, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, components and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

## Claims

1. A display module comprising:
an array substrate comprising a base substrate;
a first cover plate on a light-emitting side of the array substrate;
a second cover plate on a side of the first cover plate away from the array substrate; and
a first light-shielding layer on a side of the first cover plate close to the array substrate,
wherein an orthographic projection of the first light-shielding layer on the base substrate falls within an orthographic projection of the first cover plate on the base substrate, and the first light-shielding layer is arranged around an edge of the first cover plate.

2. The display module according to claim 1, wherein the first light-shielding layer is annular in shape and is arranged around four edges of the first cover plate, the array substrate comprises a display region, and an orthographic projection of the display region on the base substrate does not overlap with the orthographic projection of the first light-shielding layer on the base substrate.

3. The display module according to claim 1 or 2, wherein the array substrate further comprises a second light-shielding layer, the second light-shielding layer is arranged at least around a boundary of a display region, and an orthographic projection of the second light-shielding layer on the base substrate falls within an orthographic projection of the display region on the base substrate.

4. The display module according to claim 3, wherein a thickness of the first light-shielding layer is greater than a thickness of the second light-shielding layer.

5. The display module according to claim 3 or 4, wherein the first light-shielding layer and the second light-shielding layer are selected from one of: an ink, a black conductive glue, a black resin, a stacked structure comprising at least two color filter layers of different colors.

6. The display module according to claim 1, wherein the first light-shielding layer is arranged around four edges of the first cover plate, the array substrate comprises a display region, and an orthographic projection of the display region on the base substrate partially overlaps with the orthographic projection of the first light-shielding layer on the base substrate.

7. The display module according to claim 6, wherein the first light-shielding layer comprises a first portion and a second portion, an orthographic projection of the first portion on the base substrate falls within the orthographic projection of the display region on the base substrate, an orthographic projection of the second portion on the base substrate does not overlap with the orthographic projection of the display region on the base substrate, and a thickness of the first portion is smaller than a thickness of the second portion.

8. The display module according to any one of claims 1-7, further comprising an adhesive and a fixture, wherein,
the second cover plate comprises a first surface facing the first cover plate, a second surface opposite to the first surface, and a side surface connecting the first surface and the second surface, the adhesive is disposed on the side surface of the second cover plate, and the second cover plate is adhered to the fixture via the adhesive, and
a part of a surface of the first cover plate away from the array substrate is in contact with the adhesive, and the first cover plate is adhered to the second cover plate via the adhesive.

9. The display module according to claim 8, wherein an orthographic projection of the adhesive on the base substrate falls within the orthographic projection of the first light-shielding layer on the base substrate.

10. The display module according to claim 8 or 9, wherein an orthographic projection of the adhesive on the base substrate falls within an orthographic projection of the fixture on the base substrate.

11. The display module according to any one of claims 1-7, further comprising a fixture, wherein edges of the first cover plate and the second cover plate are in direct contact with the fixture.

12. The display module according to any one of claims 1-11, wherein a thickness of the second cover plate is smaller than a thickness of the first cover plate.

13. The display module according to any one of claims 1-12, wherein a distance between the first cover plate and the second cover plate is smaller than a distance between the first cover plate and the array substrate.

14. The display module according to any one of claims 1-13, wherein,
the second cover plate comprises a first surface facing the first cover plate, a second surface opposite to the first surface, and a side surface connecting the first surface and the second surface,
the first cover plate comprises a third surface facing the array substrate, a fourth surface opposite to the third surface, and a side surface connecting the third surface and the fourth surface, and
a roughness of the side surface of the second cover plate is greater than a roughness of the side surface of the first cover plate.

15. The display module according to claim 14, wherein a roughness of the third surface of the first cover plate is greater than a roughness of the fourth surface of the first cover plate.

16. The display module according to any one of claims 1-15, wherein,
the array substrate further comprises a bonding region, the bonding region is provided with a bonding electrode, and
the orthographic projection of the first cover plate on the base substrate does not overlap with an orthographic projection of the bonding electrode on the base substrate, and an orthographic projection of the second cover plate on the base substrate at least partially overlaps with the orthographic projection of the bonding electrode on the base substrate.

17. The display module according to claim 16,
wherein the first light-shielding layer comprises a first section, a second section, a third section and a fourth section connected end to end, a distance between an orthographic projection of the first section on the base substrate and the orthographic projection of the bonding electrode on the base substrate is less than distances between orthographic projections of the second section, the third section, and the fourth section on the base substrate and the orthographic projection of the bonding electrode on the base substrate, respectively, and
wherein a width of the first section along a first direction is smaller than a width of the third section along the first direction, and the width of the first section along the first direction is smaller than widths of the second section and the fourth section along a second direction, the first direction intersects with the second direction.

18. The display module according to any one of claims 1-17, further comprising a lens on a side of the second cover plate away from the first cover plate, wherein,
the lens comprises a first end and a second end opposite to the first end in a direction perpendicular to a main optical axis of the lens,
an orthographic projection of the first end on the base substrate falls outside an orthographic projection of the second cover plate on the base substrate but falls within the orthographic projection of the first cover plate on the base substrate, and
an orthographic projection of the second end on the base substrate falls outside the orthographic projection of the second cover plate on the base substrate but falls within the orthographic projection of the first cover plate on the base substrate.

19. The display module according to any one of claims 1-18, wherein an orthographic projection of the second cover plate on the base substrate falls within the orthographic projection of the first cover plate on the base substrate.

20. A display device comprising the display module according to any one of claims 1-19.
